# FASCICULE DE BREVET EUROPEEN

(11) **EP 3 520 586 B1**
(45) Date de publication et mention de la délivrance du brevet: **18.05.2022**
(21) Numéro de dépôt: 17777048.4
(22) Date de dépôt: 28.09.2017
(51) Int. Cl.: H05K 7/14, B64D 43/00, H05K 7/20, G06F 1/20, B64D 13/06

(54) **AERONEF AYANT DES CALCULATEURS REPARTIS DANS LE FUSELAGE**
FLUGZEUG MIT IM RUMPF VERTEILTEN COMPUTERN
AIRCRAFT HAVING COMPUTERS DISTRIBUTED IN THE FUSELAGE

(30) Priorité: 30.09.2016 FR 1659469
(43) Date de publication de la demande: 07.08.2019
(73) Titulaire: Safran Electronics & Defense, 75015 Paris (FR); Safran Electrical & Power, 31702 Blagnac Cedex (FR)
(72) Inventeur: GUILLOT, François, 77550 MOISSY-CRAMAYEL (FR); BLINEAU, Jean-Marc, 77550 MOISSY-CRAMAYEL (FR); AVIGNON, Philippe, 77550 MOISSY-CRAMAYEL (FR); ROQUES, Serge, 77550 MOISSY-CRAMAYEL (FR); ALBERO, Franck, 77550 MOISSY-CRAMAYEL (FR)
(74) Mandataire: Lavialle, Bruno François Stéphane
(86) Numéro de dépôt international: PCT/EP2017/074726
(87) Numéro de publication internationale: WO 2018/060392

(56) Documents cités:
- WO-A1-2014/198957
- FR-A1- 2 974 682
- US-A1- 2006 082 970

## Description

La présente invention concerne le domaine de l'aéronautique.

### ETAT DE LA TECHNIQUE

Un aéronef de transport de voyageurs comprend généralement un fuselage divisé par un plancher en un volume supérieur, la cabine, comportant des sièges recevant les voyageurs, et un volume inférieur, la soute, accueillant les bagages des voyageurs. Dans le volume inférieur s'étendent des poutrelles supportant le plancher et délimitant avec le fuselage et le plancher deux logements latéraux (couramment appelés « zones triangle cargo ») qui ont une section transversale sensiblement triangulaire et qui s'étendent parallèlement à une direction longitudinale du fuselage de part et d'autre d'une zone médiane (couramment appelée « zone utile cargo »). En raison de leur forme, les logements latéraux sont considérés comme un volume mort utilisé uniquement pour y faire courir les divers câbles et conduites de fluide servant au fonctionnement de l'aéronef et de ses équipements.

Il est connu d'installer dans la zone médiane du volume inférieur, généralement au voisinage du poste de pilotage de l'aéronef, des unités de calcul ou baies comprenant chacune un boîtier définissant un compartiment contenant des modules de calcul insérables dans le compartiment selon une direction d'insertion par une ouverture de celui-ci et raccordables à des connecteurs portés par une paroi de fond du compartiment pour déboucher dans le compartiment à l'opposé de l'ouverture. Par « module de calcul », on entend tout circuit électronique susceptible de traiter des signaux et/ou des données, et notamment de faire des calculs sur ces signaux ou ces données. Le circuit électronique peut être constitutif d'un ordinateur et comprendre un ensemble de processeurs de type ASIC ou autre, un réseau programmable de type FPGA... Les modules de calcul sont principalement reliés aux instruments de commande sur lesquels agit le pilote de l'aéronef, à des indicateurs pour l'information du pilote, à des capteurs répartis dans l'aéronef et à des équipements de l'aéronef.

La recherche de l'optimisation de l'occupation de l'espace dans l'aéronef rend problématique l'implantation des unités de calcul à bord de l'aéronef. Le document WO 2014/198957 décrit un meuble électronique, globalement parallélépipédique et équipé d'au moins un module d'interconnexion amovible pourvu d'une paroi de fond comportant une carte de fond connectée à un ensemble de modules électroniques. La paroi arrière est prolongée par des bords pourvus de connecteurs aptes à être couplés à des connecteurs agencés sur une face latérale du module d'interconnexion amovible. Des moyens de fermeture et de verrouillage libérable dudit au moins un module d'interconnexion amovible sont prévus entre une poignée de module d'interconnexion et la paroi latérale du meuble.

### OBJET DE L'INVENTION

Un but de l'invention est de fournir une solution à ce problème.

### BREF EXPOSE DE L'INVENTION

A cet effet, on prévoit, selon l'invention, un aéronef selon la revendication 1. Des caractéristiques optionnelles de l'invention sont décrites dans les revendications indépendantes qui suivent.

Ainsi, l'invention permet l'utilisation des logements latéraux du volume inférieur en y logeant des unités de calcul sans nuire excessivement à l'accessibilité des modules de calcul et des connecteurs permettant le raccordement des modules de calcul au faisceau électrique de l'aéronef.

Selon une première caractéristique particulière, le boîtier délimite un compartiment auxiliaire pour un module commun de refroidissement relié à un conduit d'air de refroidissement.

Le module commun comprend alors de préférence un clapet anti-retour agencé pour autoriser un passage d'air de refroidissement du conduit vers le module commun et s'opposer à une circulation d'air en sens opposé, et le module commun comprend une prise d'air extérieur associée à un ventilateur d'introduction d'air dans le module commun et à un clapet anti-retour agencé pour autoriser un passage d'air depuis le ventilateur vers le module commun et s'opposer à une circulation d'air en sens opposé.

Avantageusement, le module commun comprend une prise d'air extérieur et un ventilateur qui est monté en regard de cette prise d'air et qui est associé à dispositif de filtrage d'air par centrifugation.

Selon une deuxième caractéristique particulière, l'un des modules électroniques est agencé selon deux sens opposés l'un à l'autre d'une direction d'introduction dans le compartiment, le compartiment comprenant des moyens d'alimentation électrique du module électronique et des moyens de connexion de l'unité électronique au module électronique, ces moyens débouchant sur une face de branchement appartenant au compartiment de réception s'étendant parallèlement à la direction d'introduction.

Selon une troisième caractéristique particulière, au moins un des modules de calcul comprend des broches destinées à être engagées dans des trous métallisés d'une plaque de circuit imprimé, la plaque de circuit imprimé étant recouverte d'une couche de matériau souple électriquement isolant qui est percée par les broches lorsque celles-ci sont engagées dans les trous métallisés et est serrée entre un support des broches et la plaque de circuit imprimé.

D'autres caractéristiques et avantages de l'invention ressortiront à la lecture de la description qui suit de modes de réalisation particuliers non limitatifs de l'invention.

### BREVE DESCRIPTION DES FIGURES

Il sera fait référence aux dessins annexés, parmi lesquels :

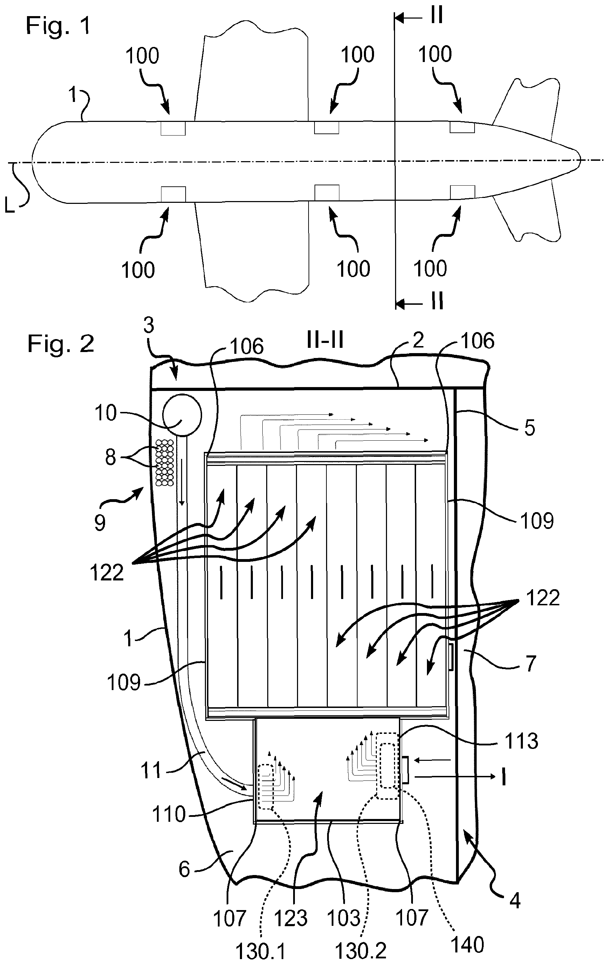

- la figure 1 est une vue schématique d'un aéronef selon l'invention ;
- la figure 2 est une vue schématique en coupe de cet aéronef selon la ligne II de la figure 1 ;

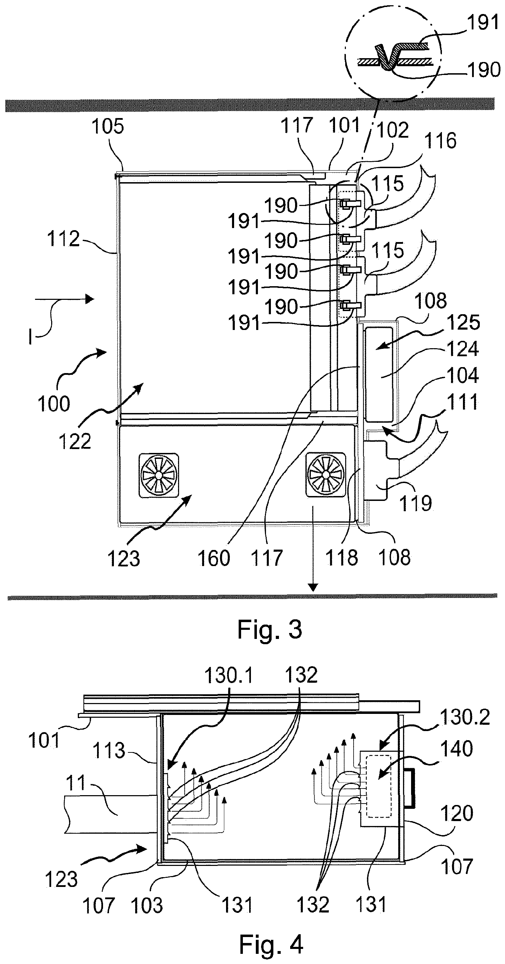

- la figure 3 est une vue schématique de côté d'une unité de calcul selon l'invention ;
- la figure 4 est une vue schématique agrandie et en coupe selon le plan II de la figure 1 du module commun de refroidissement et d'alimentation ;

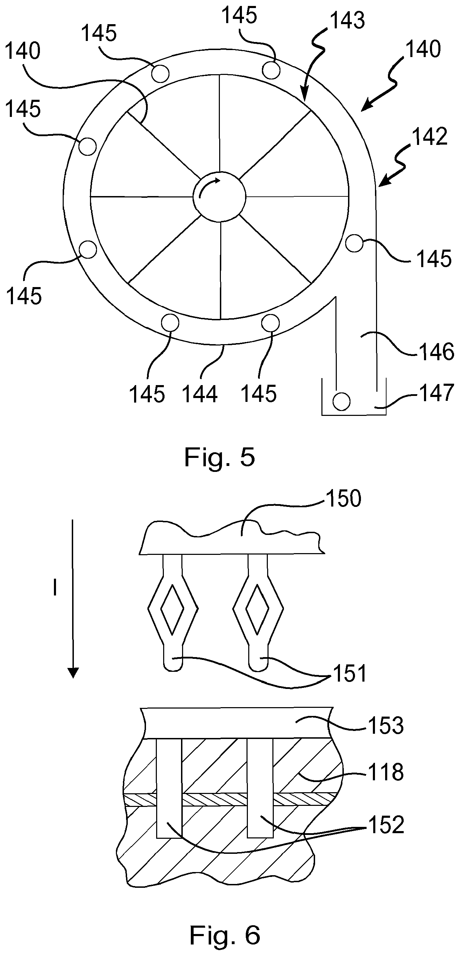

- la figure 5 est une vue schématique de face d'un ventilateur de ce module commun de refroidissement et d'alimentation ;
- la figure 6 est une vue en coupe transversale montrant le raccordement d'un des modules de calcul à une plaque de circuit imprimé ;
- la figure 7 est une vue partielle en perspective d'un compartiment d'une unité de calcul et d'un premier type de module électronique destiné à y être monté ;
- la figure 8 est une vue schématique d'un circuit électronique d'un premier type de module électronique selon l'invention ;
- la figure 9 est une vue schématique en perspective d'un deuxième type de module électronique selon l'invention ;
- la figure 10 est une vue identique à la figure 1 sur laquelle sont représentés les modules électroniques avant leur installation dans les unités de calcul ;
- la figure 11 est une vue de détail en coupe selon un plan XI-XI de la figure 7, pour montrer une étape de montage d'un module électronique dans une unité de calcul selon l'invention ;
- la figure 12 est une vue de détail en coupe selon le plan XI-XI d'un module électronique monté dans une unité de calcul selon l'invention ;
- la figure 13 est une vue schématique d'une face de branchement d'un mode de réalisation particulier d'une unité de calcul selon l'invention ;
- la figure 14 est une vue, en coupe longitudinale selon un plan XIV-XIV de la figure 13, de cette unité de calcul ;
- la figure 15 est une vue schématique d'une face de branchement d'un module commun selon un mode de réalisation particulier de l'invention ;
- la figure 16 est une vue, en coupe selon le plan XIV-XIV, montrant l'assemblage de l'unité de calcul de la figure 14 et le module commun de la figure 15.
- la figure 17 est une vue similaire à celle de la figure 16 montrant une première étape de dépose du module commun ;
- la figure 18 est une vue similaire à celle de la figure 16 montrant une deuxième étape de dépose du module commun ;
- la figure 19 est une vue similaire à celle de la figure 16 montrant une troisième étape de dépose du module commun.

### DESCRIPTION DETAILLEE DE L'INVENTION

En référence aux figures, l'aéronef comprend généralement un fuselage 1 divisé par un plancher 2 en un volume supérieur 3 et un volume inférieur 4. Le volume supérieur 3 est destiné à recevoir des sièges pour accueillir des voyageurs et constitue la cabine de l'aéronef ; le volume inférieur 4 est destiné à recevoir les bagages des voyageurs ou du fret et constitue la soute de l'aéronef.

Dans le volume inférieur 4 s'étendent des poutrelles 5 supportant le plancher 2 et délimitant avec le fuselage 1 et le plancher 2 deux logements latéraux 6 qui ont une section transversale sensiblement triangulaire et qui s'étendent parallèlement à une direction longitudinale L du fuselage 1 de part et d'autre d'une zone médiane ou centrale 7. Dans les logements latéraux 6 courent sous le plancher 2 des câbles 8 du faisceau électrique 9 de l'aéronef et l'une des conduites principales ou tubulure 10 de climatisation transportant l'air soufflé dans le volume supérieur 3 pour le climatiser. Le faisceau électrique 9 comprend des câbles utilisés pour la transmission de puissance et des câbles pour la transmission de signaux de commande et de données.

L'aéronef comprend des unités de calcul 100 comprenant chacune un boîtier 101 définissant un compartiment principal 102, un premier compartiment auxiliaire 103 s'étendant sous le compartiment principal 102 et un deuxième compartiment auxiliaire 104 s'étendant derrière une partie supérieure du premier compartiment auxiliaire 102 et derrière une partie inférieure du compartiment principal 102. Le boîtier 101 comprend une ouverture frontale 105 d'accès au compartiment principal 102 ; deux ouvertures latérales 106 d'accès au compartiment principal 102 ; deux ouvertures latérales 107, à l'opposé l'une de l'autre, d'accès au premier compartiment auxiliaire 103 ; et deux ouvertures latérales 108, à l'opposé l'une de l'autre, d'accès au deuxième compartiment auxiliaire 104. L'ouverture frontale 105 est laissée ouverte ; les ouvertures latérales 106 sont fermées par un panneau amovible 109 ; les ouvertures latérales 107, 108 orientées vers la zone médiane 7 sont laissées ouvertes ; les ouvertures latérales 107, 108 orientées à l'opposé de la zone médiane 7 sont fermées par un panneau amovible 110, 111. Les panneaux amovibles sont maintenus en position fermée par un mécanisme de verrouillage rapide ou par des vis. Les panneaux 110, 111 peuvent être montés sur l'une ou l'autre des ouvertures latérales 107, 108 selon le sens de montage de l'unité de calcul 100 dans le logement latéral 6 comme on le verra dans la suite.

Le compartiment principal 102 contient des modules de calcul, généralement désignés en 122; le premier compartiment auxiliaire 103 contient un module commun, généralement désigné en 123, de refroidissement et d'alimentation des modules de calcul 122; et le deuxième compartiment auxiliaire 104 contient un module commun, généralement désigné en 124, d'interconnexion des modules de calcul 122. Les modules communs 123, 124 assurent une fonction transversale pour les modules de calcul 122.

Les modules de calcul 122 sont insérables dans le compartiment principal 102 selon une direction d'insertion I par l'ouverture frontale 105 du boîtier 101 et sont raccordables à des connecteurs 115 portés par une paroi de fond 116 du boîtier 101 de manière à déboucher dans le compartiment principal 102 à l'opposé de l'ouverture frontale 105. Les modules de calcul 122 ont une face avant en débord qui est fixée sur le boîtier 101 et qui obture partiellement l'ouverture 105 (cette ouverture étant totalement obturée lorsque tous les modules de calcul 122 sont en place). Les connecteurs 115 sont reliés à des câbles du faisceau électrique 9 principalement dédiés à la transmission de signaux de commande et de données de manière à relier les modules de calcul 122 principalement aux instruments de commande sur lesquels agit le pilote de l'aéronef, à des indicateurs pour l'information du pilote, à des capteurs répartis dans l'aéronef et à des équipements de l'aéronef.

Avantageusement, la paroi de fond 116 comprend des moyens de fixation rapide des connecteurs 115 sur le boitier 101- ici des encoches 190 recevant des pattes élastiques 191 portées par les connecteurs 115. Les connecteurs 115, ainsi fixés sur le boîtier 101, contribuent au positionnement et au maintien mécanique des modules 122 et permettent de minimiser les effets des hyper-statismes entre les modules 122 et le boîtier 101. Les connecteurs 115 sont agencés pour être reliés en direct sur les modules 122 (c'est-à-dire que chaque connecteur 115 coopère avec un connecteur directement porté par un module). Le boitier 101 est ainsi dépourvu des habituels « blocs de fond » chargés de réaliser l'interconnexion électronique spécifique entre les connecteurs 115 portés par les câbles du réseau électrique 9 et les modules 122. Ainsi, la spécificité de la connexion d'un module 122 au faisceau électrique 9 est portée exclusivement par un connecteur 115, et les fonctions (interconnexion, alimentation électrique, refroidissement, ..) communes à tous les modules 122 sont assurées à l'aide des modules communs 123 et 124. Cet aspect particulier de l'invention contribue à réduire le nombre de références de pièces (« Part Number ») qui doivent être stockées pour les opérations de maintenance et de dépannage et réduit également le coût de fabrication d'une unité de calcul 100 car le boîtier 101 ne requiert plus de bloc de fond spécifique pour assurer l'interconnexion entre le connecteur 115 et le module 122.

La configuration particulière des unités de calcul 100 permet un accès aisé aux parois de fond 116 des boitiers 101, garantissant une intervention rapide lors de la connexion ou déconnexion des modules 122 au faisceau électrique 9 ou lors de l'installation ou pour des opérations de maintenance.

Les modules de calcul 122 comprennent une plaque de circuit imprimé portant des composants électroniques de commande et/ou de puissance : ils sont connus en eux-mêmes et ne seront pas plus détaillés ici. Les modules de calcul 122 portent également sur leur bord opposé à l'ouverture 105 un connecteur permettant leur raccordement à un connecteur porté par une face d'une plaque de circuit imprimé 118 qui sépare la partie inférieure du fond du compartiment principal 102 et le second compartiment auxiliaire 104 et se prolonge jusque dans le premier compartiment auxiliaire 103. Les modules de calcul 122 sont montés dans le compartiment principal 102 par l'intermédiaire de glissières 117 qui sont fixées dans le boîtier 1 pour s'étendre perpendiculairement à l'ouverture 105 et donc parallèlement à la direction d'insertion I. Les glissières 117 sont en matériau thermiquement conducteur pour drainer par conduction une partie de la chaleur produite par les composants électroniques des modules de calcul 122 vers le boîtier 101. Le boîtier 101 est à cette fin réalisé au moins en partie en matériau thermiquement conducteur de manière à permettre une évacuation vers l'extérieur de la chaleur produite par le fonctionnement des modules de calcul 122. En outre, le boîtier est pourvu d'ouvertures sur sa paroi supérieure pour permettre l'échappement d'un flux convectif.

Le connecteur des modules de calcul 122 permettant leur raccordement à la plaque de circuit imprimé 118 comporte un support 150 en saillie duquel s'étendent, parallèlement à la direction d'insertion I, des broches 151 élastiquement déformables dans un plan transversal à leur axe longitudinal entre un état de relâchement et un état déformé, les broches 151 ayant une section transversale plus importante dans l'état de relâchement que dans l'état déformé. Le connecteur correspondant de la plaque de circuit imprimé 118 comprend des trous métallisés 152 destinés chacun à accueillir une des broches 151 qui est engagée à force dans le trou métallisé et s'y trouve serrée dans son état déformé. La plaque de circuit imprimé 118 n'est pas placée dans une enceinte étanche contre les poussières. Dans un avion à fuselage de carbone, il existe un risque que des poussières de carbone se déposent sur la plaque de circuit imprimé et créent des courts-circuits. Pour éviter cela, la plaque de circuit imprimé 118 est recouverte d'une couche de matériau électriquement isolant 153 qui est percée par les broches 151 lorsque celles-ci sont engagées dans les trous métallisés 152. Lorsque les modules de calcul 122 sont connectés à la plaque de circuit imprimé 118, la couche de matériau électriquement isolant 153 est serrée entre les supports 150 et la plaque de circuit imprimé 118, ce qui tend à refermer les déchirures occasionnées par les broches 151 et empêche les poussières de s'introduire entre les modules de calcul 122 et la plaque de circuit imprimé 118. Le matériau électriquement isolant est ici un silicone et plus particulièrement un silicone vulcanisable à température ambiante (ou RTV pour « Room Temperature Vulcanization »). Bien entendu, tout matériau ayant un comportement élastomérique peut être utilisé, et notamment d'autres types de silicone.

Le module commun 123 est inséré dans le premier compartiment auxiliaire 103 par l'ouverture latérale 107 orientée vers la zone médiane 7 selon une direction d'insertion P perpendiculaire à la direction d'insertion I. Le module commun 123 a une face avant 112 en débord qui est fixée sur le boîtier 101 et qui obture l'ouverture 107.

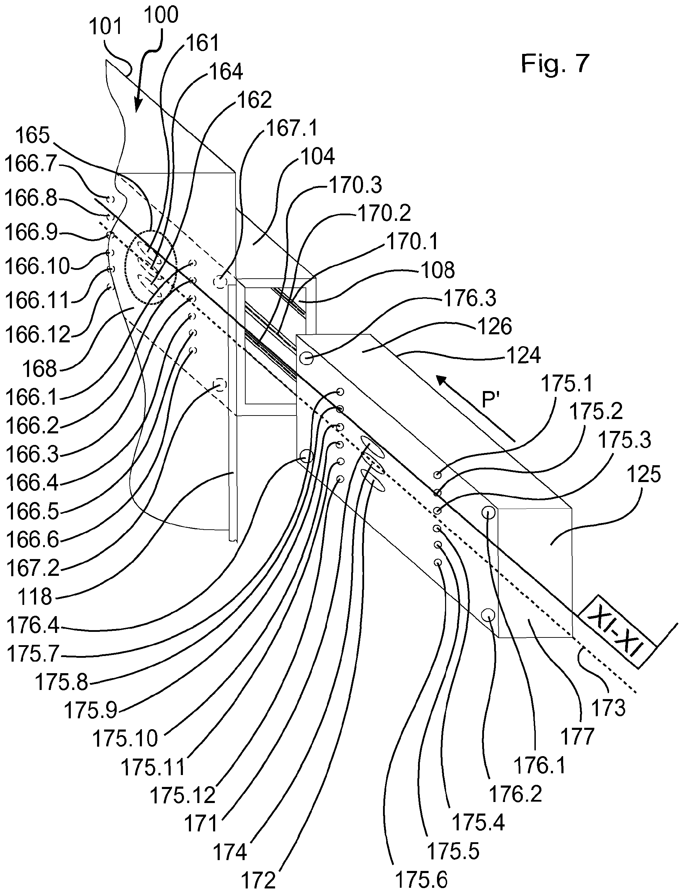

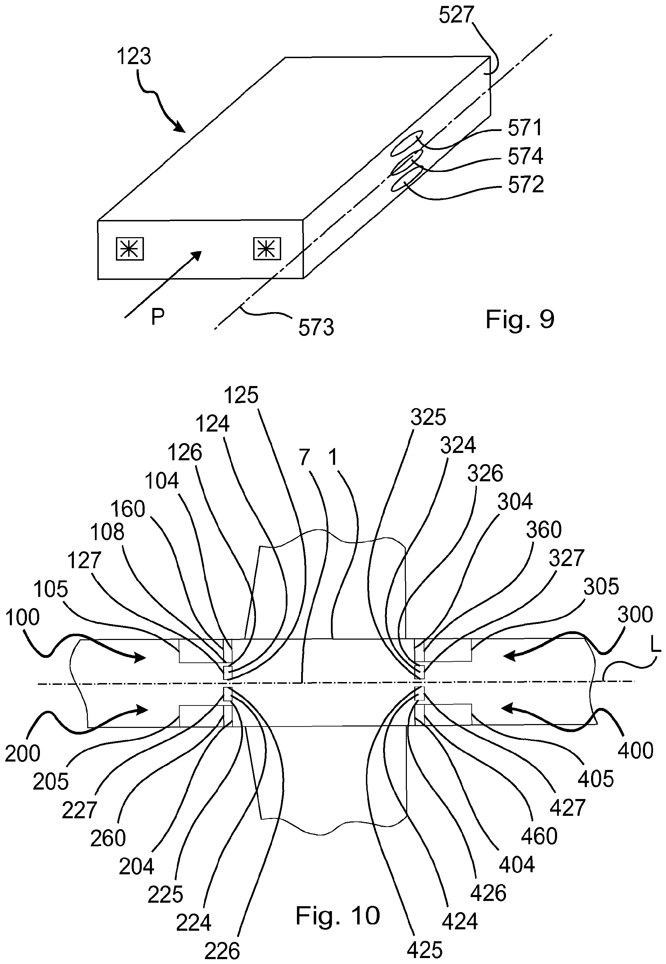

Comme visible sur les figures 7 et 10, le module commun 124 est inséré dans le deuxième compartiment auxiliaire 104 par l'ouverture latérale 108 orientée vers la zone médiane 7 selon une direction d'insertion P' perpendiculaire à la direction d'insertion I. Le module commun 124 a une face avant en débord qui est fixée sur le boîtier 101 et qui obture l'ouverture 108.

Les modules communs 123 et 124 portent tous deux des contacts flexibles leur permettant d'être raccordés à des plages conductrices de la plaque de circuit imprimé 118 qui est elle-même raccordée, d'une part, aux modules de calcul 122 comme cela a été mentionné plus haut et, d'autre part, à un connecteur 119 porté par la paroi de fond 116 et relié à des câbles de puissance et de commande du faisceau électrique 9.

Les contacts flexibles sont disposés de part et d'autre d'une ligne médiane parallèle à la direction d'insertion de telle manière que les contacts destinés à recevoir l'alimentation comportent un pôle positif et un pôle négatif s'étendant selon une ligne perpendiculaire à la ligne médiane avec l'un des pôles au-dessus de la ligne médiane et l'autre des pôles au-dessous de la ligne médiane.

Le deuxième compartiment auxiliaire 104 comprend une face de branchement 160 s'étendant parallèlement à la direction d'introduction P', face au circuit imprimé 118. Une première plage conductrice 161 et une deuxième plage conductrice 162 disposées de part et d'autre d'une ligne médiane 163 de la face de branchement 160 débouchent sur la face de branchement 160. Une plage conductrice centrale 164 située sur la ligne médiane 163 débouche également sur la face de branchement 160. Les plages conductrices 161, 162 et 164 sont oblongues et s'étendent selon une direction parallèle à la ligne médiane 163. La première plage conductrice 161 est reliée à une première piste du circuit imprimé 118 et constitue un pôle positif d'une alimentation électrique 165, la deuxième plage conductrice 162 est quant à elle reliée à une deuxième piste du circuit imprimé 118 et constitue un pôle négatif d'une alimentation électrique 165. La piste conductrice centrale 164 constitue une masse de l'alimentation électrique 165. Des coupleurs magnétiques 166.1 à 166.12 débouchent également sur la face de branchement 160. Une première série de coupleurs magnétiques comprend des coupleurs magnétiques 166.1 à 166.6 qui s'étendent symétriquement de part et d'autre de la ligne médiane 163 à proximité d'une première ouverture 108 du compartiment 104. Une deuxième série de coupleurs magnétiques comprend des coupleurs magnétiques 166.7 à 166.12 qui s'étendent symétriquement de part et d'autre de la ligne médiane 163 à proximité d'une deuxième ouverture 108 du compartiment 104 opposée à la première ouverture 108. Des coupleurs optiques 167.1 à 167.4 débouchent eux aussi sur la face de branchement 160. Une première série de coupleurs optiques comprend les coupleurs optiques 167.1 et 167.2 qui s'étendent symétriquement de part et d'autre de la ligne médiane 163 à proximité d'une première ouverture 108 du compartiment 104. Une deuxième série de coupleurs optiques comprend des coupleurs optiques 167.3 et 167.4 qui s'étendent symétriquement de part et d'autre de la ligne médiane 163 à proximité d'une deuxième ouverture 108 du compartiment 104 opposée à la première ouverture 108. La première série de coupleurs optiques 167.1 et 167.2 et la première série de coupleurs magnétiques 166.1 à 166.6 sont respectivement symétriques à la deuxième série de coupleurs optiques 167.3 et 167.4 et la deuxième série de coupleurs magnétiques 166.7 à 166.12 par rapport à un plan médian de la face 160 orthogonal à la direction médiane 163.

Les coupleurs magnétiques 166.1 à 166.12 et optiques 167.1 à 167.4 sont reliés au circuit imprimé 118. La face de branchement 160 est recouverte d'une fine couche 168 de PTFE et la face 169 opposée à la face de branchement 160 comprend trois ressorts 170.1 à 170.3 longitudinaux s'étendant parallèlement à ligne médiane 163. Le circuit imprimé 118 est raccordé, d'une part, aux modules de calcul 122 comme cela a été mentionné plus haut et, d'autre part, à un connecteur 119 porté par la paroi de fond 116 et relié à des câbles de puissance et de commande du faisceau électrique 9.

Le module 124 est ici de forme sensiblement parallélépipédique et comprend deux extrémités d'introduction respectivement 125 et 126 du module 124 dans le compartiment 104 selon deux sens opposés de la direction d'introduction P'. Le module 124 comprend également une face de branchement 127 au boitier 100 sur laquelle débouchent un premier et un deuxième contact flexible respectivement, 171 et 172, disposés de part et d'autre d'une ligne médiane 173 de la face de branchement 127. Un troisième contact flexible central 174 situé sur la ligne médiane 173 débouche également sur la face de branchement 127. Comme visible sur la figure 7, les contacts flexibles 171, 172 et 174 s'étendent selon une direction parallèle à la ligne médiane 173 et la face de branchement 127 s'étend parallèlement à la direction d'introduction P'. Des coupleurs magnétiques 175.1 à 175.12 débouchent également sur la face de branchement 127. Une première série de coupleurs magnétiques comprend des coupleurs magnétiques 175.1 à 175.6 qui s'étendent symétriquement de part et d'autre de la ligne médiane 173 à proximité de l'extrémité d'introduction 125. Une deuxième série de coupleurs magnétiques comprend des coupleurs magnétiques 175.7 à 175.12 qui s'étendent symétriquement de part et d'autre de la ligne médiane 173 à proximité de l'extrémité d'introduction 126. Des coupleurs optiques 176.1 à 176.4 débouchent eux aussi sur la face de branchement 127 et s'étendent symétriquement de part et d'autre de la ligne médiane 173. Une première série de coupleurs optiques comprend des coupleurs optiques 176.1 et 176.2 qui s'étendent symétriquement de part et d'autre de la ligne médiane 173 à proximité de l'extrémité d'introduction 125. Une deuxième série de coupleurs optiques comprend des coupleurs optiques 176.3 et 176.4 qui s'étendent symétriquement de part et d'autre de la ligne médiane 173 à proximité de l'extrémité d'introduction 126. La première série de coupleurs optiques 176.1 et 176.2 et la première série de coupleurs magnétiques 175.1 à 175.6 sont respectivement symétriques à la deuxième série de coupleurs optiques 176.3 et 176.4 et la deuxième série de coupleurs magnétiques 175.7 à 175.12 par rapport à un plan médian de la face 127 orthogonal à la direction médiane 173.La face de branchement 127 est recouverte d'une fine couche 177 de PTFE.

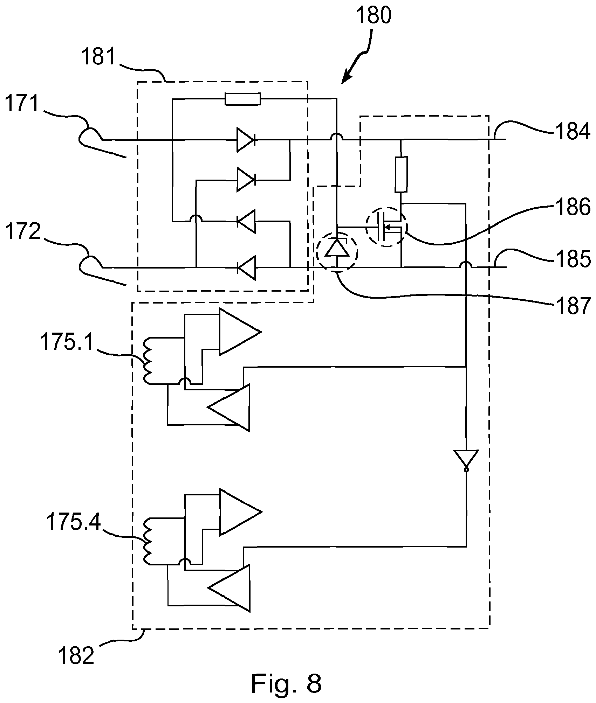

Les contacts flexibles 171 et 172, les coupleurs magnétiques 175.1 à 175.12 et optiques 176.1 à 176.4 sont reliés à un circuit électronique 180 qui comprend un premier circuit 181 et un deuxième circuit 182. Pour des raisons de clarté, seuls deux coupleurs magnétiques 175.1 et 175.4 sur l'ensemble des coupleurs magnétiques 175.1 à 175.6 et optiques 176.1 et 176.2 seront représentés sur le schéma de la figure 8. Les contacts flexibles 171 et 172 sont reliés aux bornes d'entrée d'un premier circuit 181 qui comprend un pont de diode 183. Ce premier circuit 181 permet de restituer une polarité d'alimentation constante entre ses bornes de sortie 184 et 185 quelle que soit la polarité de la tension appliquée entre les contacts flexibles 171 et 172. Le deuxième circuit 183 est relié aux coupleurs magnétiques 175.1 et 175.4 qui sont ici des émetteurs/récepteurs dont la partie émission est mise en basse impédance en fonction de la polarité de la tension appliquée entre les contacts flexibles 171 et 172. Cette mise en basse impédance est effectuée par un transistor MOS 186 dont la grille est soumise à la tension appliquée entre les contacts flexibles 171 et 172. Une diode Zener 187 protège l'entrée du transistor MOS 186 des surtensions. Ainsi, le deuxième circuit 183 permet de modifier le sens de communication des coupleurs 175.1 et 175.4 en fonction de la polarité de la tension appliquée entre les contacts flexibles 171 et 172. Le deuxième circuit 183 étant relié de la même façon aux autres coupleurs magnétiques et optiques, il permet donc, de la même façon, de modifier le sens de communication des coupleurs magnétiques 175.1 à 175.12 et optiques 176.1 à 176.4 en fonction de la polarité de la tension appliquée entre les contacts flexibles 171 et 172.

Le module 123 comporte lui également une face de branchement 527 au boitier 100 sur laquelle débouchent un premier contact flexible 571 et un deuxième contact flexible 572, disposés de part et d'autre d'une ligne médiane 573 de la face de branchement 527. Un troisième contact flexible central 574 situé sur la ligne médiane 573 débouche également sur la face de branchement 527. Comme visible sur la figure 9, les contacts flexibles 571, 572 et 574 s'étendent selon une direction parallèle à la ligne médiane 573 et la face de branchement 527 s'étend parallèlement à la direction d'introduction P. La face de branchement 527 peut comprendre des connecteurs aérauliques (non représentés) reliés au ventilateur 140 du module 123 et des connecteurs électriques pour la surveillance de fonctionnement.

En référence à la figure 10, la mise en place de quatre modules communs 124, 224, 324, 424 identiques respectivement dans quatre unités de calcul 100, 200, 300 et 400 d'un fuselage 1 d'un aéronef va être décrite. Les éléments identiques ou analogues à ceux du module commun 124 comporteront une référence numérique augmentée respectivement d'une centaine, de deux centaines et de trois centaines pour respectivement désigner les éléments des modules communs 224, 324 et 424. Les éléments identiques ou analogues à ceux de l'unité de calcul 100 comporteront une référence numérique augmentée respectivement d'une centaine, de deux centaines et de trois centaines pour respectivement désigner les éléments des unités de calcul 200, 300 et 400.

Les unités de calcul 100 et 200 sont respectivement situées à droite et à gauche d'une direction longitudinale L du fuselage 1 et ont leurs ouvertures frontales respectives 105 et 205 débouchant vers l'avant du fuselage 1. Les unités de calcul 300 et 400 sont, quant à elles, respectivement situées à droite et à gauche d'une direction longitudinale L du fuselage 1 et ont leurs ouvertures frontales respectives 305 et 405 débouchant vers l'arrière du fuselage 1.

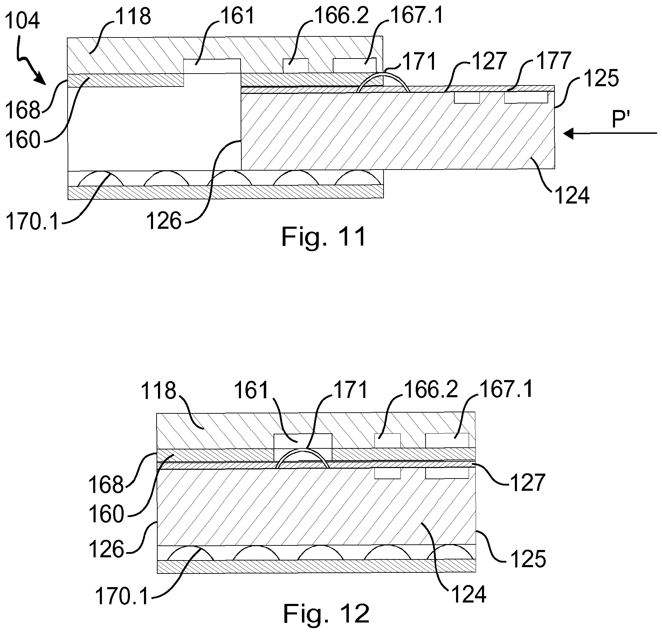

Le montage du module commun 124 dans le compartiment 104 de l'unité 100 se fait en introduisant l'extrémité d'introduction 126 du module commun 124 dans l'ouverture latérale 108 orientée vers la zone médiane 7 du compartiment 104 selon une direction d'introduction P' perpendiculaire à la direction longitudinale L, la face de branchement 127 étant orientée vers l'avant du fuselage 1. Lors de la translation du module commun 123 dans le compartiment 104, les couches de PTFE 168 et 177 respectives des faces de branchement 160 et 127 sont mises en contact sous l'effet des ressorts longitudinaux 170.1 à 170.3 et glissent l'une contre l'autre. Comme visible en figure 11, les contacts flexibles 171, 172 et 174 sont repoussés par la face de branchement 160 lors de leur entrée dans le deuxième compartiment auxiliaire 104 et glissent contre la couche de PTFE 168 de la face de branchement 160 jusqu'à ce qu'ils se trouvent respectivement face aux plages conductrices 161, 162 et 164. Dans cette position, les coupleurs optiques 176.1 à 176.4 ainsi que les coupleurs magnétiques 175.1 à 175.12 de la face de branchement 127 du module commun 124 font respectivement face aux coupleurs optiques 167.1 à 167.4 et aux coupleurs magnétiques 166.1 à 166.12 de la face de branchement 160 du deuxième compartiment auxiliaire 104. Les couches 168 et 177 garantissent également une distance maitrisée entre les faces de branchement 160 et 127. Le pôle positif constitué par la première plage conductrice 161 de l'alimentation électrique 165 du deuxième compartiment auxiliaire 104 est en contact électrique avec le contact flexible 171 du module commun 124. Le pôle négatif constitué par la deuxième plage conductrice 162 de l'alimentation électrique 165 du deuxième compartiment auxiliaire 104 est, quant à lui, en contact électrique avec le contact flexible 172 du module commun 124. Ainsi, le premier circuit 181 reçoit une tension U₁₇₁₋₁₇₂, mesurée entre les premier et deuxième contacts flexibles 171 et 172, positive. Le deuxième circuit 182 passe alors les coupleurs magnétiques 175.1 à 175.3 et 175.7 à 175.9 ainsi que les coupleurs optiques 176.1 et 176.3 en mode « émission » et les coupleurs magnétiques 175.4 à 175.6, 175.9 à 175.12 et les coupleurs optique 176.2 et 176.4 en mode « réception ». La dépose du module commun 124 hors du deuxième compartiment auxiliaire 104 se fait en saisissant l'extrémité 125 du module commun 124 afin de le faire translater selon la direction P'. Au cours de cette translation, les contacts flexibles 171, 172 et 174 sont repoussés par la face de branchement 160 et glissent contre la couche de PTFE 168 de la face de branchement 160 jusqu'à l'extraction complète du module commun 124 hors du deuxième compartiment auxiliaire 104.

Le montage du module commun 224 dans le compartiment 204 de l'unité 200 se fait en introduisant l'extrémité d'introduction 225 du module commun 224 dans l'ouverture latérale 208 orientée vers la zone médiane 7 du deuxième compartiment auxiliaire 204 selon une direction d'introduction P' perpendiculaire à la direction longitudinale L, la face de branchement 227 étant orientée vers l'avant du fuselage 1. Dans cette position, les coupleurs optiques 276.1 à 276.4 ainsi que les coupleurs magnétiques 276.1 à 276.12 de la face de branchement 227 du module commun 224 font respectivement face aux coupleurs optiques 267.1 à 267.4 et aux coupleurs magnétiques 266.1 à 266.12 de la face de branchement 260 du deuxième compartiment auxiliaire 204. Le pôle positif constitué par la première plage conductrice 261 de l'alimentation électrique 265 du deuxième compartiment auxiliaire 204 est en contact électrique avec le contact flexible 271 du module commun 224. Le pôle négatif constitué par la deuxième plage conductrice 262 de l'alimentation électrique 265 du deuxième compartiment auxiliaire 204 est, quant à lui, en contact électrique avec le contact flexible 272 du module commun 224. Ainsi, le premier circuit 281 reçoit une tension U₂₇₁₋₂₇₂, mesurée entre les premier et deuxième contacts flexibles 271 et 272, positive. Le deuxième circuit 282 passe alors les coupleurs magnétiques 275.1 à 275.3 et 275.7 à 275.9 ainsi que les coupleurs optiques 276.1 et 276.3 en mode « émission » et les coupleurs magnétiques 275.4 à 275.6, 275.10 à 275.12 et les coupleurs optiques 276.2 et 276.4 en mode « réception ».

Le montage du module commun 324 dans le compartiment 304 de l'unité 300 se fait en introduisant l'extrémité d'introduction 326 du module commun 324 dans l'ouverture latérale 308 orientée vers la zone médiane 7 du deuxième compartiment auxiliaire 304 selon une direction d'introduction P' perpendiculaire à la direction longitudinale L, la face de branchement 327 étant orientée vers l'arrière du fuselage 1. Dans cette position, les coupleurs optiques 376.1, 376.2, 376.3, 376.4 ainsi que les coupleurs magnétiques 375.1 à 375.6 et 375.7 à 375.12 de la face de branchement 327 du module commun 324 font respectivement face aux coupleurs optiques 367.4, 367.3, 367.2 et 367.1 et aux coupleurs magnétiques 366.12 à 366.7 et 366.6 à 366.1 de la face de branchement 360 du deuxième compartiment auxiliaire 304. Le pôle positif constitué par la première plage conductrice 361 de l'alimentation électrique 365 du deuxième compartiment auxiliaire 304 est en contact électrique avec le contact flexible 372 du module commun 324. Le pôle négatif constitué par la deuxième plage conductrice 362 de l'alimentation électrique 365 du deuxième compartiment auxiliaire 304 est, quant à lui, en contact électrique avec le contact flexible 372 du module commun 324. Ainsi, le premier circuit 381 reçoit une tension U₃₇₁₋₃₇₂, mesurée entre les premier et deuxième contacts flexibles 371 et 372, négative. Le deuxième circuit 382 passe alors les coupleurs magnétiques 375.1 à 375.3, 375.7 à 375.9 et les coupleurs optiques 376.1 et 376.3 en mode « réception »et les coupleurs magnétiques 375.4 à 375.6, 375.10 à 375.12 et les coupleurs optiques 376.2 et 376.4 en mode « émission ».

Le montage du module commun 424 dans le compartiment 404 de l'unité 400 se fait en introduisant l'extrémité d'introduction 425 du module commun 424 dans l'ouverture latérale 408 orientée vers la zone médiane 7 du deuxième compartiment auxiliaire 404 selon une direction d'introduction P' perpendiculaire à la direction longitudinale L, la face de branchement 427 étant orientée vers l'arrière du fuselage 1. Dans cette position, les coupleurs optiques 476.1, 476.2, 476.3, 476.4 ainsi que les coupleurs magnétiques 475.1 à 475.6 et 475.7 à 475.12 de la face de branchement 427 du module commun 424 font respectivement face aux coupleurs optiques 467.4, 467.3, 467.2, 467.1 et aux coupleurs magnétiques 466.12 à 466.7 et 466.6 à 466.1 de la face de branchement 460 du deuxième compartiment auxiliaire 404. Le pôle positif constitué par la première plage conductrice 461 de l'alimentation électrique 465 du deuxième compartiment auxiliaire 404 est en contact électrique avec le contact flexible 472 du module commun 424. Le pôle négatif constitué par la deuxième plage conductrice 462 de l'alimentation électrique 465 du deuxième compartiment auxiliaire 404 est, quant à lui, en contact électrique avec le contact flexible 472 du module commun 424. Ainsi, le premier circuit 481 reçoit une tension U₄₇₁₋₄₇₂, mesurée entre les premier et deuxième contacts flexibles 471 et 472, négative. Le deuxième circuit 482 passe alors les coupleurs magnétiques 475.1, 475.2, 475.3 et le coupleur optique 476.1 en mode « réception »et les coupleurs magnétiques 475.4, 475.5, 475.6 et 476.2 en mode « émission ».

On comprend que l'agencement décrit plus haut des contacts flexibles permet d'utiliser des modules communs 124, 224, 324, 424 identiques dans les unités de calcul 100, 200, 300 et 400 puisqu'il suffit de renverser le module commun autour de son axe longitudinal pour que les contacts électriques se trouvent soit à gauche soit à droite.

On obtient alors un unique modèle d'unité de calcul coopérant avec un unique type de module et pouvant être monté dans quatre configurations différentes sans modifications. Les coûts de certification, de production, de maintenance et d'installation sont ainsi fortement réduits.

Les éléments identiques ou analogues à ceux de l'unité de calcul 100 comporteront une référence numérique augmentée respectivement de quatre centaines dans la description qui suit d'un mode de réalisation particulier d'une unité de calcul selon l'invention.

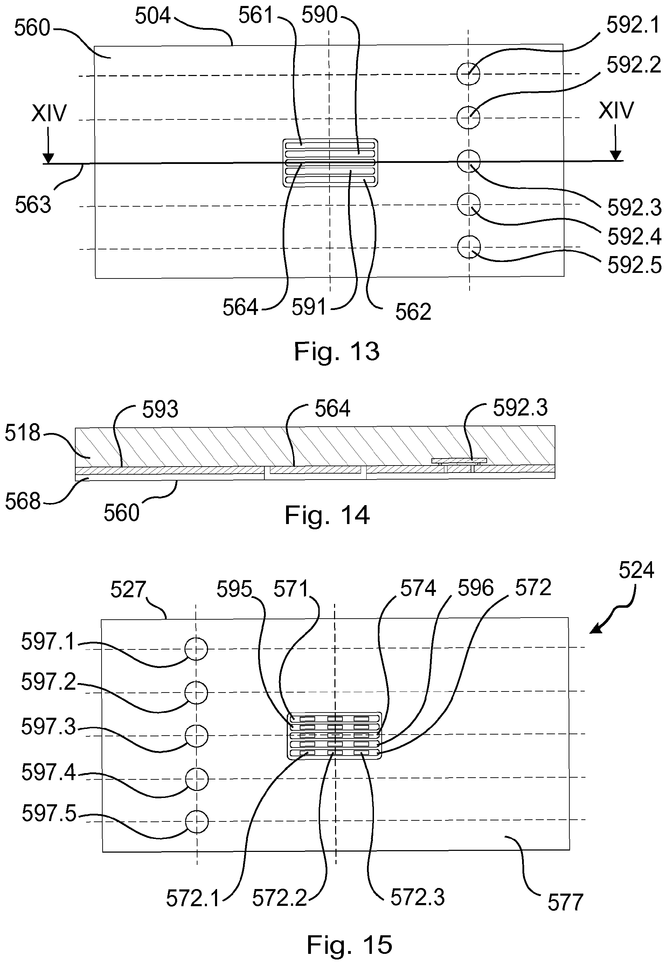

En référence à la figure 13, la face de branchement 560 du deuxième logement auxiliaire 504 comprend cinq pistes conductrices 561, 562, 564, 590 et 591. La première plage conductrice 561 est reliée à une première piste du circuit imprimé 518 et constitue un pôle positif d'une alimentation électrique 565, la deuxième plage conductrice 562 est quant à elle reliée à une deuxième piste du circuit imprimé 518 et constitue un pôle négatif d'une alimentation électrique 565. La piste conductrice centrale 564 constitue une masse de l'alimentation électrique 565. Les pistes supplémentaires 590 et 591 qui s'étendent symétriquement par rapport à ligne médiane 563 sont respectivement des ports d'entrée et de sortie de communication. Des coupleurs magnétiques 592.1 à 592.5 débouchent également sur la face de branchement 560. Ces coupleurs magnétiques s'étendent symétriquement de part et d'autre de la ligne médiane 563 à proximité d'une première ouverture 508 du compartiment 504.

Comme visible en figure 14, le circuit imprimé 518 comprend une plaque métallique 593 s'étendant sur toute la surface de branchement 560 et sur laquelle sont fixée les plages conductrices 561, 562, 564, 590, 591 ainsi que les enroulements des coupleurs magnétiques 592.1 à 592.5. La couche de PTFE 568 recouvre la plaque 593 et comprend une réservation à l'aplomb des plages conductrices 561, 562, 564, 590, 591. Le circuit imprimé 518 comprend également des cylindres 594.1 à 594.5 de blindage des coupleurs magnétiques 592.1 à 592.5 s'étendant à proximité de la face de la plaque 593 opposée à la couche 568.

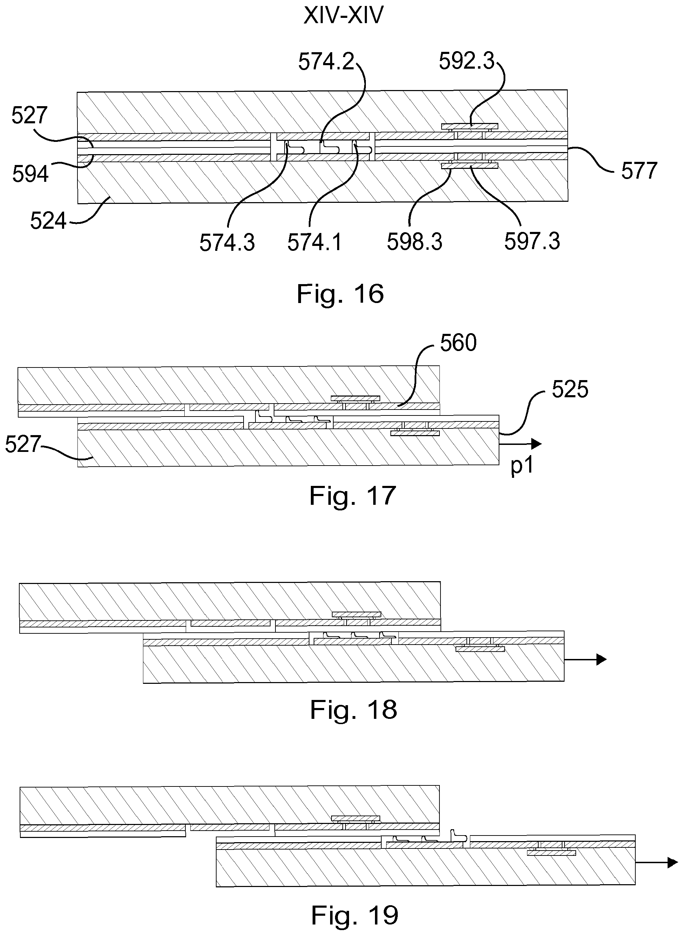

Comme visible aux figures 15 et 16, la face de branchement 527 du module commun 524 comprend également une plaque métallique 594 s'étendant sur toute la surface de branchement 560 et sur laquelle sont fixée des contacts flexibles 571, 572, 574, 595, 596 ainsi que des enroulements des coupleurs magnétiques 597.1 à 597.5. Les contacts flexibles 571, 572, 574, 595, 596 comprennent respectivement trois pontets élastiques 571.1 à 571.3, 572.1 à 572.3, 574.1 à 574.3, 595.1 à 595.3, 596.1 à 596.3. La couche de PTFE 577 recouvre la plaque 594 et comprend une réservation à l'aplomb des plages conductrices 571, 572, 574, 595, 596. La face de branchement 560 comprend également des cylindres 598.1 à 594.5 de blindage des coupleurs magnétiques 592.1 à 592.5 s'étendant à proximité de la face de la plaque 593 opposée à la couche 568.

Lorsque le module commun 524 est en place dans le deuxième logement auxiliaire 504 (figure 16), les coupleurs magnétiques 597.1 à 597.5 du module commun 524 font face aux coupleurs magnétiques 592.1 à 592.5 de l'unité de calcul 500, assurant ainsi le couplage magnétique de l'unité 500 et du module 524. Les pontets élastiques des contacts flexibles 571, 572, 574, 595 et 596 viennent respectivement au contact des plages conductrices 561, 562, 564, 590 et 591, assurant l'alimentation du module commun 524 par l'alimentation 565 et la mise en communication du module commun 524 avec l'unité de calcul 500. Les plaques métalliques 593 et 594 en regard assurent un efficace couplage capacitif entre le module commun 524 et l'unité de calcul 500.

La dépose du module commun 524 hors du deuxième compartiment auxiliaire 504 se fait en saisissant l'extrémité 525 du module commun 524 afin de le faire translater selon la direction P'. Au cours de cette translation, les pontets des contacts flexibles 571, 572 et 574 sont repoussés par la face de branchement 560 et glissent contre la couche de PTFE 568 de la face de branchement 560 jusqu'à l'extraction complète du module commun 524 hors du deuxième compartiment auxiliaire 104 (figures 17 à 19.

Les unités de calcul 100 sont disposées dans au moins l'un des logements latéraux 6 de telle manière que la direction d'insertion I soit sensiblement parallèle à la direction longitudinale L du fuselage 1. On notera que le retrait du panneau 109 permet d'accéder directement au module de calcul 122 le plus proche de la zone médiane 7.

Plus précisément, les unités de calcul 100 sont montées par paires en des positions adjacentes dans les logements latéraux 6 de telle manière que les parois de fond 116 des boîtiers 101 s'étendent en regard l'une de l'autre. Des câbles 8 du faisceau électrique 9 sont amenés entre les deux unités de calcul 100 pour être connectés à celles-ci via les connecteurs 115 et 119, ce qui facilite le raccordement des unités de calcul 100 au faisceau électrique 9.

On comprend que l'agencement décrit plus haut des contacts flexibles permet d'utiliser des modules communs 123 et 124 identiques dans les deux unités de calcul 100 puisqu'il suffit de renverser le module commun autour de son axe longitudinal et de la direction d'insertion pour que les contacts électriques se trouvent soit à gauche soit à droite.

Le module commun 123 va maintenant être détaillé. Un conduit 11, s'étendant entre le fuselage 1 et l'unité de calcul 100, relie la conduite principale 10 la plus proche à une prise d'air monté sur le panneau 110 pour déboucher en regard d'une ouverture du module commun 113 en regard de laquelle est monté un premier clapet anti-retour 130.1 agencé pour autoriser un passage de l'air de refroidissement du conduit 11 jusque dans le module commun 123 et s'opposer à une circulation d'air en sens opposé. Le module commun 123 comprend une prise d'air extérieur 120 qui débouche dans la zone centrale 7 et qui est associée à un ventilateur 140 d'introduction d'air dans le module commun 123 et à un deuxième clapet anti-retour 130.2 agencé pour autoriser un passage d'air depuis le ventilateur 140 jusque dans le module commun 123 et s'opposer à une circulation d'air en sens opposé. Le module commun 123 a une paroi supérieure pourvue d'ouvertures d'évacuation d'air vers le compartiment principal 102.

Les clapets 130.1 et 130.2 sont similaires l'un à l'autre et comprennent ici un corps 131, creux, fixé à une des parois latérales du module commun 123 et raccordé de manière étanche au conduit 11 pour le clapet 130.1 et à la sortie du ventilateur 140 pour le clapet 130.2. Le corps 131 est pourvu d'une pluralité d'ouvertures en regard de chacune desquelles est monté un volet 132 ayant un bord libre et à l'opposé un bord articulé au corps 131 de telle manière que le volet 132 pivote entre une position fermée et une position ouverte. Les volets 132 sont ainsi positionnés de telle manière que les volets 132 puissent être soulevés par un flux d'air allant en direction de l'intérieur du module commun 123 de manière à laisser passer ce flux d'air mais soient plaqués en position fermée par tout flux d'air ayant une direction opposée. Le moyen de rappel est par exemple un ressort taré pour autoriser le soulèvement des volets 132 par le flux d'air entrant dans le module commun 123 sans occasionner une perte de charge dans le flux d'air empêchant celui-ci de parcourir le module commun 123 et le compartiment principal 102. En variante, le moyen de rappel peut être la gravité. On comprend que :
- lorsque le système de soufflage d'air de l'aéronef est en fonctionnement, le clapet anti-retour 130.1 laisse passer l'air tandis que le ventilateur 140 est arrêté et que le clapet anti-retour 130.2 empêche le passage de l'air provenant du clapet anti-retour 130.1 ;
- lorsque le système de soufflage d'air de l'aéronef est défaillant, le ventilateur 140 est mis en fonctionnement pour souffler de l'air que le clapet anti-retour 130.2 laisse passer tandis que le clapet anti-retour 130.1 empêche le passage de l'air provenant du clapet anti-retour 130.2. La mise en action du ventilateur 140 est commandée via le faisceau électrique 9 après détection de la défaillance du système de soufflage d'air de l'aéronef.

Le ventilateur 140 comprend ici une roue à aubes 141 entraînée, par un moteur électrique non représenté, en rotation dans un carter 142. Le carter 142 comprend deux parois 143 perpendiculaires à l'axe de rotation de la roue à aubes 141 réunies par une paroi périphérique circulaire 144 entourant la roue à aubes 141 qui s'étend entre les parois 143. L'une des parois 143 est fixée à la paroi du module commun 123 et l'autre des parois 143 est pourvu d'orifices 145 d'échappement d'air au voisinage de la paroi périphérique circulaire 144 tout en étant écartés de la paroi périphérique circulaire 144. La paroi périphérique circulaire 144 s'étend autour de la roue à aubes 141 et ayant une partie inférieure prolongée tangentiellement par un couloir tangentiel vertical 146 auquel est fixé un réceptacle 147. La roue à aubes 141 comprend un moyeu creux formant un conduit en communication avec la prise d'air 120 de telle manière que la rotation de la roue à aubes 141 tende à entraîner l'air provenant de la prise d'air 120 vers les orifices 145 du carter 142. Les poussières qui pourraient se trouver dans le flux d'air sont entraînées par un effet de centrifugation contre la paroi périphérique circulaire 144 jusque dans le couloir tangentiel vertical 146 et le réceptacle 147 où les poussières seront piégées. Le nettoyage du réceptacle 147 permet de retirer les poussières.

Bien entendu, l'invention n'est pas limitée aux modes de réalisation décrits mais englobe toute variante entrant dans le champ de l'invention telle que définie par les revendications.

En particulier, le boîtier de l'unité de calcul 100 peut avoir une autre forme et comprendre un nombre différent de compartiment auxiliaire ou pas de compartiment auxiliaire du tout.

Bien qu'ici le module décrit soit un module commun aux modules de calcul, l'invention s'applique également à d'autres types de module électronique comme par exemple des modules de ventilation ou des modules dédiés une partie des modules de calcul ou à un seul de ceux-ci.

Bien qu'ici l'alimentation du module électronique se fasse à l'aide de plages conductrices oblongues, l'invention s'applique également à d'autres moyens d'alimentation électrique du module électronique comme par exemple des plages conductrices circulaires ou des connecteurs sans contact inductifs.

Bien qu'ici les faces de branchement du module électronique et du deuxième compartiment auxiliaire comprennent un revêtement en PTFE, l'invention s'applique également à d'autres types de revêtement réduisant les frottements comme par exemple du PCTFE, FE, MFA ou d'autres polymères. L'invention s'applique également à une seule face de branchement -du module électronique ou de l'unité de calcul- qui soit pourvue d'un revêtement réduisant les frottements. Le revêtement pouvant s'étendre sur toute la face de branchement ou seulement sur une partie de celle-ci.

Bien qu'ici le deuxième compartiment auxiliaire comporte trois ressorts longitudinaux, l'invention s'applique également à d'autres types d'éléments élastiques agencés pour exercer un effort de mise en contact contre la face de branchement comme par exemple un unique ressort longitudinal, des lames en caoutchouc ou des ressorts hélicoïdaux.

Bien qu'ici le module commun soit de forme sensiblement parallélépipédique, l'invention s'applique également à des modules de forme différente comme par exemple de modules triangulaires ou cylindriques droits.

Bien qu'ici le module électronique comprenne des contacts flexibles, l'invention s'applique également à d'autres moyens de liaison à une alimentation électrique comme par exemple des plots électriques fixes, des connecteurs sans contact inductifs ou des balais conducteurs.

Bien qu'ici le module électronique, tout comme l'unité de calcul, comprenne des coupleurs optiques et des coupleurs magnétiques, l'invention s'applique également à d'autres moyens de connexion comme par exemple des plages conductrices ou des émetteurs récepteurs radio ou micro-ondes. Les connecteurs magnétiques et/ou optiques sont préférés car ils permettent un découplage électrique du module électronique et de l'unité de calcul.

Bien qu'ici les moyens de connexion soient répartis symétriquement par rapport à un axe médian et un plan orthogonal à cet axe, l'invention s'applique également à des moyens de connexion répartis différemment, il est alors requis d'également renverser le module commun autour d'un axe perpendiculaire à sa direction d'introduction. Dans ce cas particulier, l'insertion du module commun dans le compartiment se fait toujours par la même extrémité d'introduction. Bien qu'ici l'unité soit une unité de calcul, l'invention s'applique également à d'autres types d'unité électroniques comme par exemple une unité de communication, de climatisation ou autre.

Bien qu'ici la paroi de fond du boitier comprenne des encoches recevant des pattes élastiques portées par les connecteurs, l'invention s'applique également à d'autres moyens de fixation rapide des connecteurs sur le boitier, comme par exemple des raccords à baïonnette, aimantés, des fiches élastiques, des goupilles.

En variante, le module commun est agencé pour assurer une seule fonction transversale et par exemple une alimentation en énergie des modules de calcul, un refroidissement des modules de calcul ou une interconnexion des modules de calcul.

En variante, on peut utiliser des modules communs destinés à n'être utilisés que dans une seule position soit ayant des contacts flexibles à droite, soit avec des contacts flexibles à gauche. En variante encore, les modules communs ont un fond équipé d'un connecteur et le boîtier de l'unité de calcul peut être équipé d'un connecteur homologue déplaçable pour être monté sur le panneau de fond des compartiments auxiliaires, quel que soit le sens de montage de l'unité de calcul dans le logement latéral.

Des moyens de ventilation peuvent être utilisés et par exemple un ventilateur disposé derrière un filtre chargé d'empêcher l'introduction de poussière dans le module commun de refroidissement.

## Revendications

1. Aéronef comprenant un fuselage (1) et des unités de calcul (100) réparties dans le fuselage, le fuselage étant divisé par un plancher (2) en un volume supérieur (3) et un volume inférieur (4) dans lequel s'étendent des poutrelles (5) supportant le plancher et délimitant avec le fuselage et le plancher deux logements latéraux (6) qui ont une section transversale sensiblement triangulaire et qui s'étendent parallèlement à une direction longitudinale du fuselage, les unités de calcul étant disposées dans le volume inférieur et comprenant chacune un boîtier (101) définissant un compartiment principal (102) contenant des modules de calcul (122) insérables dans le compartiment principal selon une direction d'insertion (I) par une première ouverture (105) de celui-ci et raccordables à des connecteurs (115) portés par une paroi de fond (116) du compartiment principal pour déboucher dans le compartiment principal à l'opposé de la première ouverture, les unités de calcul étant disposées dans au moins l'un des logements latéraux de telle manière que la direction d'insertion soit sensiblement parallèle à la direction longitudinale du fuselage,
dans lequel l'aéronef comprend un circuit de climatisation du volume supérieur (3), le circuit de climatisation comprenant une tubulure (10) de soufflage d'air qui s'étend sous le plancher (2) dans les logements latéraux (6) du volume inférieur (4) et qui est raccordée à un module commun (123) de refroidissement des modules de calcul de chaque unité de calcul, le module commun de refroidissement étant disposé sous les modules de calcul (122) et en communication avec le compartiment principal (102) et le boîtier (101) comprenant un évent d'évacuation d'air débouchant dans le compartiment principal au-dessus des modules de calcul, le module commun de refroidissement (123) étant relié à la tubulure (10) par un conduit (11) s'étendant entre le fuselage (1) et l'unité de calcul (100).

2. Aéronef selon la revendication 1, dans lequel le boitier (101) comprend des moyens de fixation rapide (190) des connecteurs (115) sur le boitier (101), les connecteurs (115) étant agencés pour être reliés en direct sur les modules (122).

3. Aéronef selon la revendication 2, dans lequel les moyens de fixation rapide des connecteurs (115) sur le boitier (101), comprennent des encoches (190) sur la paroi de fond (116) recevant des pattes élastiques (191) portées par les connecteurs (115).

4. Aéronef selon l'une quelconque des revendications précédentes, dans lequel le module commun (123) comprend un clapet anti-retour (130.1) agencé pour autoriser un passage d'air de refroidissement du conduit (11) vers le module commun et s'opposer à une circulation d'air en sens opposé, et le module commun comprend une prise d'air extérieur associée à un ventilateur (140) d'introduction d'air dans le module commun et à un clapet anti-retour (130.2) agencé pour autoriser un passage d'air depuis le ventilateur vers le module commun et s'opposer à une circulation d'air en sens opposé.

5. Aéronef selon l'une quelconque des revendications précédentes, dans lequel le module commun (123) comprend une prise d'air extérieur et un ventilateur (140) qui est monté en regard de cette prise d'air et qui est associé à dispositif de filtrage d'air par centrifugation.

6. Aéronef selon la revendication 5, dans lequel le ventilateur (140) comprend une roue à aubes (141) entraînée par un moteur électrique en rotation dans un carter (142) une paroi périphérique circulaire (144) prolongée tangentiellement par un couloir tangentiel vertical (146) ayant une extrémité inférieure à laquelle est fixé un réceptacle (147) de récupération de poussières, le carter comprenant un orifice d'entrée de l'air au voisinage de l'axe de rotation de la roue et au moins un orifice de sortie d'air au voisinage de la paroi périphérique circulaire.

7. Aéronef selon l'une quelconque des revendications précédentes, dans lequel le boîtier (101) des unités de calcul (100) délimite un compartiment auxiliaire (104) recevant un module commun (124) qui assure une fonction transversale pour les modules de calcul (122) et qui est inséré dans le compartiment auxiliaire par une ouverture selon une direction d'insertion perpendiculaire à la direction longitudinale du fuselage de telle manière que l'ouverture du compartiment auxiliaire soit orientée vers une zone médiane du volume inférieur (4).

8. Aéronef selon la revendication 7, dans lequel le module commun (123) est agencé pour assurer une alimentation des modules de calcul (122) en énergie.

9. Aéronef selon la revendication 7, dans lequel le module commun (124) est agencé pour assurer une transmission de données avec les modules de calcul (122).

10. Aéronef selon la revendication 7, dans lequel le module commun (123) est agencé pour assurer un refroidissement des modules de calcul (122).

11. Aéronef selon l'une au moins des revendications 7 à 10, dans lequel au moins un connecteur débouche sur un côté du compartiment auxiliaire adjacent à l'ouverture du compartiment auxiliaire (104) pour coopérer avec un connecteur latéral du module commun (124) et permettre une connexion électrique lors de l'insertion du module commun dans le compartiment auxiliaire.

12. Aéronef selon l'une quelconque des revendications précédentes, comprenant deux unités de calcul (100) montées en des positions adjacentes dans le même logement latéral (6), les parois de fond (116) des boîtiers (101) s'étendant en regard l'une de l'autre.

13. Aéronef selon l'une quelconque des revendications précédentes, dans lequel le boîtier (101) possède une deuxième ouverture d'accès au compartiment principal (102), la deuxième ouverture étant réalisée sur un côté du boîtier perpendiculaire à la première ouverture.

14. Aéronef selon l'une quelconque des revendications précédentes, dans lequel l'un des modules électroniques (124, 224, 324, 424) est agencé selon deux sens opposés l'un à l'autre d'une direction d'introduction (P') dans le compartiment, le compartiment comprenant des moyens d'alimentation électrique (125, 225, 325, 425) du module électronique (124, 224, 324, 424) et des moyens de connexion (166.1-166.12, 167.1-167.4) de l'unité électronique (100, 200, 300, 400) au module électronique (124, 224, 324, 424), ces moyens débouchant sur une face de branchement (160) appartenant au compartiment de réception (104, 204, 304, 404) s'étendant parallèlement à la direction d'introduction (P').

15. Aéronef selon la revendication 14, dans lequel les moyens d'alimentation (125, 225, 325, 425) comprennent une première plage conductrice (161, 261, 361, 461) et une deuxième plage conductrice (162, 262, 362, 462) disposées de part et d'autre d'une ligne médiane (163) de la face de branchement(160, 260, 360, 460), une des première et deuxième plages conductrices(161, 261, 361, 461) étant le pôle positif de l'alimentation électrique du module électronique, l'autre des première et deuxième plages conductrices (162, 262, 362, 462) étant le pôle négatif de l'alimentation électrique du module électronique.

16. Aéronef selon la revendication 15, dans lequel les plages conductrices (161, 261, 361, 461, 162, 262, 362, 462) s'étendent selon une direction parallèle à la ligne médiane (163).

17. Aéronef selon l'une quelconque des revendications 14 à 16, dans lequel la face de branchement (160, 260, 360, 460) comprend au moins partiellement un revêtement réduisant les frottements (168).

18. Aéronef selon l'une quelconque des revendications 14 à 17, dans lequel les moyens de connexion (166.1-166.12, 167.1-167.4) du module électronique à l'unité électronique comprennent au moins un coupleur magnétique (166.1-166.12).

19. Aéronef selon l'une quelconque des revendications 14 à 18, dans lequel les moyens de connexion 166.1-166.12, 167.1-167.4) du module électronique à l'unité électronique comprennent au moins un coupleur optique (167.1-167.4).

20. Aéronef selon l'une quelconque des revendications 14 à 19, dans lequel une face du compartiment opposée à la face de branchement comprend au moins un élément élastique (170.1-170.3) agencé pour exercer un effort de mise en contact contre la face de branchement (160, 260, 360, 460).

21. Aéronef selon l'une quelconque des revendications précédentes, dans lequel au moins un des modules de calcul comprend des broches (151) destinées à être engagées dans des trous métallisés (152) d'une plaque de circuit imprimé (118), la plaque de circuit imprimé (118) étant recouverte d'une couche de matériau souple électriquement isolant (153) qui est percée par les broches (151) lorsque celles-ci sont engagées dans les trous métallisés (152) et est serrée entre un support (150) des broches et la plaque de circuit imprimé (118).

22. Aéronef selon la revendication précédente, dans lequel le matériau électriquement isolant est un silicone et plus particulièrement un silicone vulcanisable à température ambiante.

## Patentansprüche

1. Luftfahrzeug, umfassend einen Rumpf (1) und in dem Rumpf verteilte Recheneinheiten (100), wobei der Rumpf durch einen Zwischenboden (2) in ein oberes Volumen (3) und ein unteres Volumen (4) unterteilt ist, in dem sich Balken (5) erstrecken, die den Zwischenboden stützen und mit dem Rumpf und dem Zwischenboden zwei seitliche Aufnahmen (6) begrenzen, die einen im Wesentlichen dreieckigen Querschnitt haben und sich parallel zu einer Längsrichtung des Rumpfes erstecken, wobei die Recheneinheiten in dem unteren Volumen angeordnet sind und jeweils ein Gehäuse (101) umfassen, das ein Hauptfach (102) definiert, das Rechenmodule (122) enthält, die in das Hauptfach durch eine erste Öffnung (105) desselben in einer Einführrichtung (I) einführbar und mit Verbindern (115) verbindbar sind, die von einer Bodenwand (116) des Hauptfaches so getragen werden, dass sie in das Hauptfach gegenüber der ersten Öffnung münden, wobei die Recheneinheiten in mindestens einer der seitlichen Aufnahmen derart angeordnet sind, dass die Einführrichtung im Wesentlichen parallel zur Längsrichtung des Rumpfes ist, wobei das Luftfahrzeug einen Klimatisierungskreis zur Klimatisierung des oberen Volumens (3) umfasst, wobei der Klimatisierungskreis ein Luftblasrohr (10) umfasst, das sich unter dem Zwischenboden (2) in den seitlichen Aufnahmen (6) des unteren Volumens (4) erstreckt und das an ein gemeinsames Kühlmodul (123) zum Kühlen der Rechenmodule jeder Recheneinheit angeschlossen ist, wobei das gemeinsame Kühlmodul unter den Rechenmodulen (122) und in Kommunikation mit dem Hauptfach (102) angeordnet ist, und das Gehäuse (101) eine Luftabführungsöffnung umfasst, die über den Rechenmodulen in das Hauptfach mündet, wobei das gemeinsame Kühlmodul (123) über eine Leitung (11), die sich zwischen dem Rumpf (1) und der Recheneinheit (100) erstreckt, mit dem Rohr (10) verbunden ist.

2. Luftfahrzeug nach Anspruch 1, bei dem das Gehäuse (101) Schnellbefestigungsmittel (190) zur Befestigung der Verbinder (115) an dem Gehäuse (101) umfasst, wobei die Verbinder (115) so ausgebildet sind, dass sie direkt an die Module (122) angeschlossen werden.

3. Luftfahrzeug nach Anspruch 2, bei dem die Schnellbefestigungsmittel zur Befestigung der Verbinder (115) an dem Gehäuse (101) Kerben (190) an der Bodenwand (116) umfassen, welche elastische Laschen (191) aufnehmen, die von den Verbindern (115) getragen werden.

4. Luftfahrzeug nach einem der vorhergehenden Ansprüche, bei dem das gemeinsame Modul (123) ein Rückschlagventil (130.1) umfasst, das so ausgebildet ist, dass es einen Durchtritt von Kühlluft von der Leitung (11) zum gemeinsamen Modul gestattet und sich einer Luftzirkulation in entgegengesetzter Richtung widersetzt, und das gemeinsame Modul einen Außenlufteinlass umfasst, der mit einem Ventilator (140) zum Einbringen von Luft in das gemeinsame Modul und mit einem Rückschlagventil (130.2) verbunden ist, das so ausgebildet ist, dass es einen Durchtritt von Luft von dem Ventilator zum gemeinsamen Modul gestattet und sich einer Luftzirkulation in entgegengesetzter Richtung widersetzt.

5. Luftfahrzeug nach einem der vorhergehenden Ansprüche, bei dem das gemeinsame Modul (123) einen Außenlufteinlass und einen Ventilator (140) umfasst, der gegenüber diesem Lufteinlass angebracht und mit einer Vorrichtung zum Filtern von Luft durch Zentrifugation verbunden ist.

6. Luftfahrzeug nach Anspruch 5, bei dem der Ventilator (140) ein Flügelrad (141) umfasst, das von einem Elektromotor in Drehung in einem Gehäuse (142) angetrieben wird, eine kreisförmige Umfangswand (144), die tangential von einem vertikalen tangentialen Gang (146) verlängert ist, der ein unteren Ende hat, an dem ein Staubrückgewinnungsbehälter (147) befestigt ist, wobei das Gehäuse eine Lufteinlassöffnung nahe der Drehachse des Rades und mindestens eine Luftauslassöffnung nahe der kreisförmigen Umfangswand umfasst.

7. Luftfahrzeug nach einem der vorhergehenden Ansprüche, bei dem das Gehäuse (101) der Recheneinheiten (100) ein Hilfsfach (104) begrenzt, das ein gemeinsames Modul (124) aufnimmt, das eine transversale Funktion für die Rechenmodule (122) sicherstellt und das in das Hilfsfach durch eine Öffnung in einer Einführrichtung eingefügt wird, die senkrecht zur Längsrichtung des Rumpfes ist, derart, dass die Öffnung des Hilfsfaches zu einer Mittelzone des unteren Volumens (4) gerichtet ist.

8. Luftfahrzeug nach Anspruch 7, bei dem das gemeinsame Modul (123) ausgebildet ist, um eine Versorgung der Rechenmodule (122) mit Energie sicherzustellen.

9. Luftfahrzeug nach Anspruch 7, bei dem das gemeinsame Modul (124) so ausgebildet ist, dass es eine Datenübertragung mit den Rechenmodulen (122) sicherstellt.

10. Luftfahrzeug nach Anspruch 7, bei dem das gemeinsame Modul (123) so ausgebildet ist, dass es ein Kühlen der Rechenmodule (122) sicherstellt.

11. Luftfahrzeug nach mindestens einem der Ansprüche 7 bis 10, bei dem mindestens ein Verbinder auf einer Seite des Hilfsfaches angrenzend an die Öffnung des Hilfsfaches (104) mündet, um mit einem seitlichen Verbinder des gemeinsamen Moduls (124) zusammenzuwirken und eine elektrische Verbindung während des Einfügens des gemeinsamen Moduls in das Hilfsfach zu ermöglichen.

12. Luftfahrzeug nach einem der vorhergehenden Ansprüche, umfassend zwei Recheneinheiten (100), die in angrenzenden Positionen in derselben seitlichen Aufnahme (6) montiert sind, wobei sich die Bodenwände (116) der Gehäuse (101) einander gegenüberliegend erstrecken.

13. Luftfahrzeug nach einem der vorhergehenden Ansprüche, bei dem das Gehäuse (101) eine zweite Zugangsöffnung zum Hauptfach (102) hat, wobei die zweite Öffnung auf einer Seite des Gehäuses ausgebildet ist, die senkrecht zur ersten Öffnung ist.

14. Luftfahrzeug nach einem der vorhergehenden Ansprüche, bei dem eines der elektronischen Module (124, 224, 324, 424) in zwei zueinander entgegengesetzten Richtungen einer Einführrichtung (P') in das Fach angeordnet ist, wobei das Fach elektrische Versorgungsmittel (125, 225, 325, 425) zur elektrischen Versorgung des elektronischen Moduls (124, 224, 324, 424) und Verbindungsmittel (166.1-166.12, 167.1-167.4) zum Anschließen der elektronischen Einheit (100, 200, 300, 400) an das elektronische Modul (124, 224, 324, 424) umfasst, wobei diese Mittel auf einer Anschlussfläche (160) münden, die zum Aufnahmefach (104, 204, 304, 404) gehört und sich parallel zur Einführrichtung (P') erstreckt.

15. Luftfahrzeug nach Anspruch 14, bei dem die Versorgungsmittel (125, 225, 325, 425) einen ersten leitenden Bereich (161, 261, 361, 461) und einen zweiten leitenden Bereich (162, 262, 362, 462) umfassen, die zu beiden Seiten einer Mittellinie (163) der Anschlussfläche (160, 260, 360, 460) angeordnet sind, wobei einer der ersten und zweiten leitenden Bereiche (161, 261, 361, 461) der positive Pol der elektrischen Versorgung des elektronischen Moduls ist, während der andere der ersten und zweiten leitenden Bereiche (162, 262, 362, 462) der negative Pol der elektrischen Versorgung des elektronischen Moduls ist.

16. Luftfahrzeug nach Anspruch 15, bei dem sich die leitenden Bereiche (161, 261, 361, 461, 162, 262, 362, 462) in einer Richtung parallel zur Mittellinie (163) erstrecken.

17. Luftfahrzeug nach einem der Ansprüche 14 bis 16, bei dem die Anschlussfläche (160, 260, 360, 460) zumindest teilweise eine reibungsreduzierende Beschichtung (168) umfasst.

18. Luftfahrzeug nach einem der Ansprüche 14 bis 17, bei dem die Verbindungsmittel (166.1-166.12, 167.1-167.4) zum Anschließen des elektronischen Moduls an die elektronische Einheit mindestens einen magnetischen Koppler (166.1-166.12) umfassen.

19. Luftfahrzeug nach einem der Ansprüche 14 bis 18, bei dem die Verbindungsmittel (166.1-166.12, 167.1-167.4) zum Anschließen des elektronischen Moduls an die elektronische Einheit mindestens einen optischen Koppler (167.1-167.4) umfassen.

20. Luftfahrzeug nach einem der Ansprüche 14 bis 19, bei dem eine Fläche des Faches, die der Anschlussfläche gegenüberliegt, mindestens ein elastisches Element (170.1-170.3) umfasst, das so ausgebildet ist, dass es eine kontaktherstellende Kraft auf die Anschlussfläche (160, 260, 360, 460) ausübt.

21. Luftfahrzeug nach einem der vorhergehenden Ansprüche, bei dem mindestens eines der Rechenmodule Stifte (151) umfasst, die dazu bestimmt sind, in metallisierte Löcher (152) einer gedruckten Leiterplatte (118) eingefügt zu werden, wobei die gedruckte Leiterplatte (118) mit einer Schicht aus einem elektrisch isolierenden flexiblen Material (13) bedeckt ist, die von den Stiften (151) durchbohrt wird, wenn diese in die metallisierten Löcher (152) eingefügt werden, und die zwischen einem Träger (150) für die Stifte und der gedruckten Leiterplatte (118) eingespannt ist.

22. Luftfahrzeug nach dem vorhergehenden Anspruch, bei dem das elektrisch isolierende Material ein Silikon und insbesondere ein bei Umgebungstemperatur vulkanisierbares Silikon ist.

## Claims

1. An aircraft comprising a fuselage (1) and calculation units (100) distributed in the fuselage, the fuselage being subdivided by a floor (2) into a top volume (3) and a bottom volume (4) in which girders (5) extend supporting the floor and co-operating with the fuselage and the floor to define two lateral housings (6) that are of substantially triangular cross-section and that extend parallel to a longitudinal axis of the fuselage, the calculation units being arranged in the bottom volume and each comprising a box (101) defining a main compartment (102) containing calculation modules (122) insertable into the main compartment along an insertion axis (I) through a first opening (105) in the compartment and connectable to connectors (115) carried by a back wall (116) of the main compartment so as to extend into the main compartment opposite from the first opening, the calculation units being arranged in at least one of the lateral housings in such a manner that the insertion axis is substantially parallel to the longitudinal axis of the fuselage,
wherein the aircraft includes an air conditioning circuit for air conditioning the top volume (3), the air conditioning circuit including an air-blowing tube (10) that extends under the floor (2) in the lateral housings (6) of the bottom volume (4) and that is connected to a common cooling module (123) for cooling the calculation modules of each calculation unit, the common cooling module being arranged under the calculation means (102) and in communication with the main compartment (102), and the box (101) including an air discharge vent extending into the main compartment above the calculation modules, the common cooling module (123) being connected to the tube (10) by a duct (11) extending between the fuselage (1) and the calculation unit (100).

2. An aircraft according to claim 1, wherein the box (101) includes quick fastener means (190) for fastening the connectors (115) to the box (101), the connectors (115) being arranged to be connected directly to the modules (122).

3. An aircraft according to claim 2, wherein the quick fastener means for fastening the connectors (115) on the box (101) comprise notches (190) on the back wall (116) and resilient tabs (191) carried by the connectors (115).

4. An aircraft according to any preceding claim, wherein the common module (123) includes a check valve (130.1) arranged to allow cooling air to pass from the duct (11) towards the common module and to oppose any flow of air in the opposite direction, and the common module includes an external air intake associated with a fan (140) for introducing air into the common module and with a check valve (130.2) arranged to allow air to pass from the fan towards the common module and to oppose any flow of air in the opposite direction.

5. An aircraft according to any preceding claim, wherein the common module (123) includes an external air intake and a fan (140) that is mounted facing the air intake and that is associated with a device for filtering air by centrifuging.

6. An aircraft according to claim 5, wherein the fan (140) comprises an impeller wheel (141) driven by an electric motor to rotate in a casing (142), a circular peripheral wall (144) extended tangentially by a vertical tangential passage (146) having a bottom end with a dust-recovery container (147) fastened thereto, the casing including an air inlet orifice in the vicinity of the axis of rotation of the impeller and at least one air outlet orifice in the vicinity of the circular peripheral wall.

7. An aircraft according to any preceding claim, wherein the box (101) of the calculation units (100) defines an auxiliary compartment (104) receiving a common module (124) that performs a transverse function for the calculation modules (122) and that is inserted into the auxiliary compartment via an opening along an insertion axis perpendicular to the longitudinal axis of the fuselage in such a manner that the opening of the auxiliary compartment faces towards a middle zone of the bottom volume (4).

8. An aircraft according to claim 7, wherein the common module (123) is arranged to power the calculation modules (122) .

9. An aircraft according to claim 7, wherein the common module (124) is arranged to transmit data with the calculation modules (122).

10. An aircraft according to claim 7, wherein the common module (123) is arranged to cool the calculation modules (122) .

11. An aircraft according to any one of claims 7 to 10, wherein at least one connector extends onto a side of the auxiliary compartment adjacent to the opening of the auxiliary compartment (104) in order to cooperate with a lateral connector of the common module (124) and provide an electrical connection during insertion of the common module into the auxiliary compartment.

12. An aircraft according to any preceding claim, comprising two calculation units (100) mounted in adjacent positions in a common lateral housing (6), the back walls (116) of the boxes (101) extending facing each other.

13. An aircraft according to any preceding claim, wherein the box (101) possesses a second opening giving access to the main compartment (102), the second opening being made in a side of the box perpendicular to the first opening.

14. An aircraft according to any preceding claim, wherein one of the electronic modules (124, 224, 324, 424) is arranged along two mutually opposite directions of an insertion axis (P') for insertion into the compartment, the compartment having electrical power supply means (125, 225, 325, 425) for powering the electronic module (124, 224, 324, 424) and connection means (166.1-166.12, 167.1-167.4) of the electronic unit (100, 200, 300, 400) for connection to the electronic module (124, 224, 324, 424), these means extending onto a connection face (160) forming part of the reception compartment (104, 204, 304, 404) and extending parallel to the insertion axis (P').

15. An aircraft according to claim 14, wherein the power supply means (125, 225, 325, 425) comprise a first conductive area (161, 261, 361, 461) and a second conductive area (162, 262, 362, 462) arranged on opposite sides of a middle line (163) of the connection face (160, 260, 360, 460), one of the first and second conductive areas (161, 261, 361, 461) being the positive pole of the electrical power supply of the electronic module, the other one of the first and second conductive areas (162, 262, 362, 462) being the negative pole of the electrical power supply of the electronic module.

16. An aircraft according to claim 15, wherein the conductive areas (161, 261, 361, 461, 162, 262, 362, 462) extend along respective axes parallel to the middle line (163) .

17. An aircraft according to any one of claims 14 to 16, wherein the connection face (160, 260, 360, 460) is coated at least in part by a friction-reducing coating (168) .

18. An aircraft according to any one of claims 14 to 17, wherein the connection means (166.1-166.12, 167.1-167.4) for connecting the electronic module to the electronic unit comprise at least one magnetic coupler (166.1-166.12) .

19. An aircraft according to any one of claims 14 to 18, wherein the connection means (166.1-166.12, 167.1-167.4) for connecting the electronic module to the electronic unit comprise at least one optical coupler (167.1-167.4).

20. An aircraft according to any one of claims 14 to 19, wherein a face of the compartment opposite from the connection face includes at least one resilient element (170.1-170.3) arranged to exert a contact-making force against the connection face (160, 260, 360, 460).

21. An aircraft according to any preceding claim, wherein at least one of the calculation modules includes pins (151) for engaging in metal-plated holes (152) of a printed circuit board (118), the printed circuit board (118) being covered in a layer of electrically insulating flexible material (153) that is pierced by the pins (151) when they are engaged in the metal-plated holes (152) and that is clamped between a support (150) for the pins and the printed circuit board (118).

22. An aircraft according to the preceding claim, wherein the electrically insulating material is a silicone, and more particularly a silicone for room temperature vulcanization.
